**Europäisches Patentamt**

**European Patent Office**

**Office européen des brevets**

(19)

(11) Publication number: **0 120 956**
**B1**

(12) # EUROPEAN PATENT SPECIFICATION

(45) Date of publication of patent specification: **08.08.90**

(51) Int. Cl.⁵: **H 03 M 1/00**

(21) Application number: **83903631.6**

(22) Date of filing: **24.09.83**

(86) International application number:
**PCT/US83/01488**

(87) International publication number:
**WO 84/01245 29.03.84 Gazette 84/09**

(54) **SYSTEMS FOR PROVIDING DIGITAL REPRESENTATIONS OF ANALOG VALUES.**

(30) Priority: **24.09.82 US 422733**

(43) Date of publication of application:
**10.10.84 Bulletin 84/41**

(45) Publication of the grant of the patent:
**08.08.90 Bulletin 90/32**

(84) Designated Contracting States:
**CH DE FR GB LI NL SE**

(56) References cited:
**US-A-3 142 834     US-A-3 926 056**
**US-A-3 656 153     US-A-4 339 958**

**ELECTRONIC ENGINEERING, vol. 43, no. 518,**
**April 1971, pages 47-50, London, GB; B.E.**
**HOWSE et al.: "A d.v.m. with standards-room**
**accuracy"**
**HEWLETT PACKARD JOURNAL, vol. 25, no. 3,**
**November 1973, pages 2-10, Palo Alto, US; R.L.**
**DUDLEY et al.: "A self contained, hand-held**
**digital multimeter - a new concept in**
**instrument utility"**

(73) Proprietor: **NEIL BROWN INSTRUMENT**
**SYSTEMS INC.**
**Post Office Box 498 1140 Route 28A**
**Cataumet MA 02534 (US)**

(72) Inventor: **BROWN, Neil, L.**
**5 Seminole Circle**
**Sharon, MA 02067 (US)**

(74) Representative: **Smith, Philip Antony et al**
**REDDIE & GROSE 16 Theobalds Road**
**London WC1X 8PL (GB)**

Courier Press, Leamington Spa, England.

## Description

This invention relates generally to systems for providing digital representations of analog values and, more particularly, to such systems as used with analog sensor elements for producing digital output values representative thereof with relatively high resolution and accuracy.

A system for providing digital representations of the analog values from an analog sensor element is described in United States patent specification No. 4 536 744 published on 20th August 1985. The system described therein which was on sale before the priority date of the present application utilizes a successive approximation conversion technique using a transformer D/A converter and a dual slope integration technique, which techniques provide more useful digital representations of the analog values, particularly when such values may be changing relatively rapidly during the digital sampling interval, and also provide a more rapid operation than systems theretofore known. In accordance with the system described in such application, the most significant bits of the digital output are determined using a successive approximation register and a precision transformer D/A converter, the latter providing an AC output voltage having an amplitude which is proportional to the digital value currently provided by the successive approximation register.

The transformer D/A output is compared with the AC analog input signal from the sensor to provide a comparator output voltage representing in a suitably designed comparator an error voltage which is supplied to the successive approximation register to determine the value of each bit. In this manner, both the "sign" bit and the nine most significant bits, of an 18-bit digital output signal, for example, can be determined.

The residual error voltage which is present following the determination of the most significant bits is then demodulated and integrated for a fixed period of time, the resulting value of such integration process being digitized to provide the additional nine least significant bits in accordance with a dual-slope integration process, as described in the aforesaid application.

When using such system to provide a digital output signal, particularly one having more than 18 bits, the resolution and accuracy tends to deteriorate because the comparator circuit thereof tends to respond not only to the fundamental frequency of the basic AC oscillator signal but also to the harmonics thereof when such signal is an imperfect sine wave. Hence, it is desirable to modify the circuitry as disclosed in the above referenced application so that the comparator circuit responds only to the fundamental frequency of the basic oscillator signal so that desired resolution and accuracy can be achieved, with digital outputs particularly of greater than 18 bits, e.g. as high as 26 bits.

U.S. Patent Specification No. 3 926 056 discloses an analog-to-digital converter circuit in accordance with the preamble of claim 1.

In the circuitry described in U.S. Patent Specification No. 4 536 744 it has been found that the generation of the most significant bits seems significantly less affected by the problem of harmonic presence in the AC reference signal than does the generation of the least significant bits. Accordingly the invention which is defined by the appended claims, operates in accordance with the following principles. The comparator circuit is arranged to operate in two modes, i.e., a "most significant bit" (MSB) mode and a "least significant bit" (LSB) mode. In the LSB mode, the input signals which are compared are supplied via a preamplifier to a band-pass filter/amplifier circuit which has a very precise gain and a substantially zero phase shift. Such filter then has a high harmonic rejection capability. The output of the band-pass filter is supplied to a phase detector the output of which then passes through a first conventional, low pass filter and a second Bessell low pass filter to a dual-slope integrator circuit. The integrator output is thence supplied to a limiter to provide the digital output of the comparator for generating the least significant bits.

During the MSB mode, the output of the preamplifier bypasses the band-pass filter and is supplied to the phase detector and thence through the first low pass filter to a fixed-time integrator circuit and thence to the limiter for producing the digital output of the comparator used in generating the most significant bits.

Such comparator circuit configuration can be contrasted with the previously suggested approach wherein the output of the preamplifier circuit during the LSB mode is supplied directly to the phase detector and thence to a dual-slope integrator and limiter, while during the MSB mode the ±AC reference signals are supplied directly to the limiter to produce the comparator output.

Description of the invention

The invention can be described more specifically with the help of the accompanying drawings wherein:

Fig. 1 shows a broad block diagram of the system of the invention;

Fig. 2 shows a block diagram of the comparator circuit of the system depicted in Fig. 1;

Fig. 3 shows a diagrammatic representation of the band-pass filter/amplifier of Fig. 2;

Fig. 4 shows a circuit diagram of one embodiment of the bandpass filter/amplifier of Fig. 3;

Fig. 5 shows the amplitude and phase characteristics of the band-pass filter/amplifier of Fig. 2;

Fig. 6 shows a circuit diagram of an exemplary bi-quad amplifier used in the circuit of Fig. 4;

Fig. 7 shows a circuit diagram of the phase detector/filter of Fig. 2;

Fig. 8 depicts the waveforms of the reference voltages used in the phase detector of Fig. 7;

Fig. 9 shows a circuit diagram which is functionally equivalent to that depicted in Fig. 7;

Fig. 10 shows waveforms (A) through (E) useful in explaining the operation of the circuit of Fig. 9;

Fig. 11 shows a more detailed circuit diagram of a particular embodiment of the preamplifier of Fig. 2.

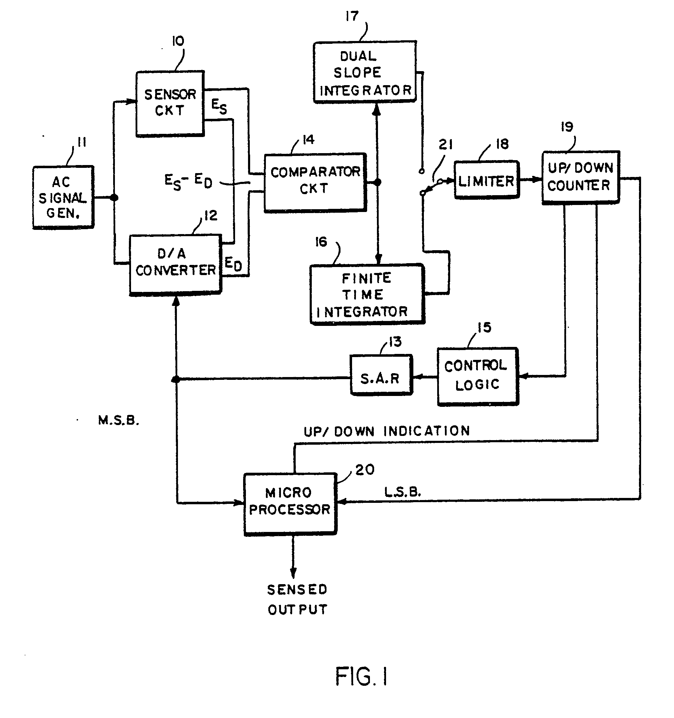

As can be seen in the block diagram of Fig. 1, which is a modified version of the general configuration discussed in U.S. Patent 4,536,744, a sensor circuit 10 is supplied with an input reference signal from AC signal generator (oscillator) 11 and provides an output analog voltage $E_S$ which represents a sensed parameter value, such as a pressure or a temperature, for example, depending on the sensor transducer which is being utilized.

The AC signal from generator 11 is supplied to a digital-to-analog (D/A) converter circuit 12 which provides an analog signal $E_D$ which is an analog representation of the output of a successive approximation register (S.A.R.) 13. $E_S$ and $E_D$ are compared at AC comparator circuit 14, to provide an error signal utilizing suitable finite time integration and dual-slope integration techniques using integrators 16 and 17, respectively, for correcting the successive approximation register 13 via control logic 15. Such integration techniques are described in U.S. Patent 4,536,744 and are further discussed below.

During a first mode of operation (when switch 21 is in the position shown), the output of the finite time integrator 16 is supplied to an up/down counter 19 via limiter 18 to successive approximation register 13 via suitable control logic 15 as discussed in U.S. Patent 4,536,744. The output of S.A.R. 13 is supplied to a suitable microprocessor 20 and effectively presents the most significant bits (MSB) of a number which in turn represents the sensor output.

During a second mode of operation (when switch 21 is in its alternate position), the output of the dual-slope integrator 17 is supplied to limiter 18 and up/down counter 19 and thence to the microprocessor 20. Such output effectively represents the least significant bits (LSB) of the number which represents the sensor output. The microprocessor 20 operates on such MSB and LSB values so as to provide a suitable indication of the value of the sensed parameter which can be suitably used by and/or displayed for the user.

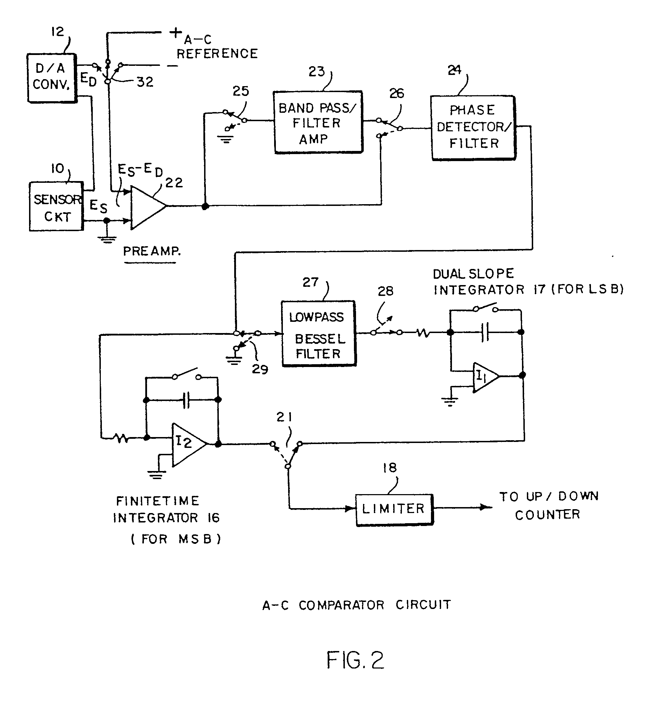

While general circuitry shown in Fig. 1 is substantially similar to that shown in U.S. Patent No. 4,536, 744, the AC comparator and integration circuits and their associated circuitry, in accordance with the invention, have a different configuration from that shown in U.S. Patent No. 4,536,744, which new configuration is depicted in more detail in Fig. 2. As can be seen therein, a comparator preamplifier circuit 22 is supplied with the input different signal $(E_S—E_D)$ representing the difference between the signal from sensor circuit 10 and the signal from D/A converter circuit 12. The output of preamplifier 22 is supplied either to a band-pass filter/amplifier circuit 23 or directly to a phase detector/filter circuit 24, depending on the positions of switches 25 and 26, as discussed in more detail below. The output of phase detector/filter 24 is supplied to a low pass Bessel filter circuit 27 via switch 29 and to the input of a fixed, or finite, time integrator circuit 16.

The output of Bessel filter 27 is supplied to a dual-slope integrator circuit 17 via switch 28. The output of either dual-slope integrator 17 or fixed time integrator 16 is supplied to limiter 18 in accordance with the position of a switch 21, the limiter output thereby providing the desired comparator output signal for supply to up/down counter 19.

In Fig. 2 switches 25, 26, 29 and 21 are shown in their selected positions for operation in the LSB mode (the solid lines used with such switches) while in their alternate positions (the dashed lines) the switches are arranged for operation in the MSB mode. Switch 28 operates in a slightly different manner, as discussed below.

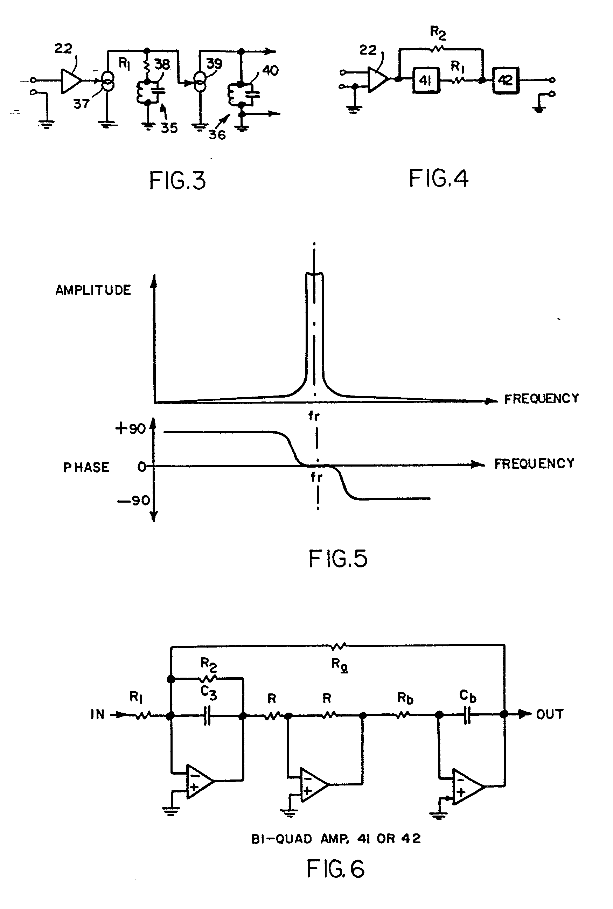

The design approach for the band-pass amplifier 23, as used in combination with the preamplifier circuit 22, is shown in Fig. 3 in diagrammatic form. As seen therein, the output of preamplifier 22 is supplied to a circuit which acts effectively as a cascaded pair of tuned feedback amplifiers 35 and 36 each effectively represented diagrammatically in the figure as comprising an AC current source 37 and 39, respectively, and parallel resonant inductance-capacitance (LC) circuits 38 and 40, respectively. Such circuits are arranged to have, in effect, an ideal open loop gain of infinity at the selected operating frequency (in a particular embodiment as described herein the operating frequency is selected to be 384 Hz) and to be completely stable under closed loop conditions. Acceptable performance can be achieved with a feedback factor of $2.5 \times 10^7$. The diagrammatic approach of Fig. 3 depicts two LC circuits each having high Q factors, e.g., up to 2000 at low audio frequencies.

One can achieve very high gain at a selected frequency, e.g., 384 Hz, by the use of a single high-Q tuned circuit. The frequency at unity gain will be given in that case approximately as 4.8 M Hz. Since the tuned circuit has a phase shift approaching 90° at frequencies well above or well below resonance, the untuned stages would have to have a combined phase shift of less than 90° for all frequencies up to 4.8 M Hz, if the amplifier is to be unconditionally stable under closed loop conditions, a situation which is clearly impractical to achieve. The difficulty increases when two tuned stages are used.

If a small resistance $R_1$ is added in series with the first tuned circuit, as shown in Fig. 3, the desired stability can be achieved. At resonance, $R_1$ is negligible but at frequencies remote from resonance $R_1$ predominates and the phase shift of the first stage approaches zero at low gain. If this stage is followed by an unmodified second stage, as in Fig. 3, it is found that the overall amplifier meets the required very high open loop gain at resonance while maintaining excellent closed loop stability.

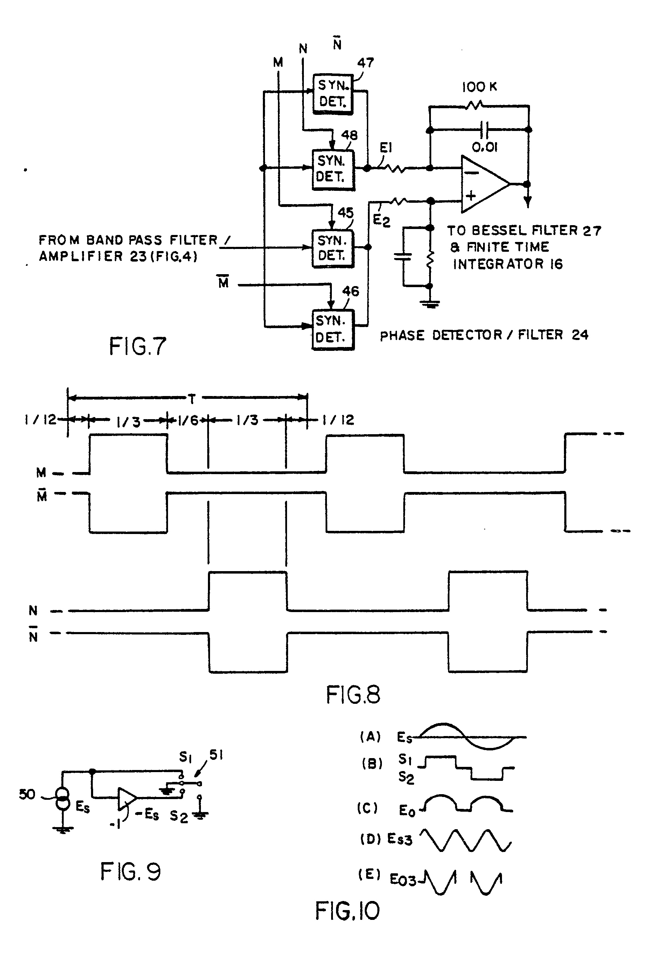

At the low audio resonant frequency of 384 Hz the circuit of Fig. 3 becomes impractical since the physical size of the inductances required are too large for most applications. An alternative technique for achieving the same result is the circuit shown in Fig. 4. Preamplifier 22 supplies an input signal to a pair of cascaded amplifiers 41 and 42 each of which can be embodied as a conventional "bi-quad" amplifier. Such circuits are well known to the art and can be found, for example, in the text "Rapid Practical Designs of Active Filters", Johnson and Hilburn, John Wiley and Sons, 1975. The resistors $R_1$ and $R_2$ (where $R_1 = 2R_2$) effectively produce the same effect as does the resistance $R_1$ in Fig. 3. The gains of each of the bi-quad amplifiers can be arranged to be 1000 and the Q's of each to be 2000. Tha overall open loop gain, for a preamplifier gain of 37.5, is greater than $25 \times 10^6$ at 384 Hz and falls below unity below 20 Hz and above 7500 Hz with phase shifts $\pm 91°$ at these frequencies.

If input and output transformers are used, their phase shifts over the 20—7500 Hz range must be relatively small ($\pm 30°$ or less) to maintain good closed loop stability. Such requirements are relatively easy to satisfy and the use of such transformers assists in providing optimum signal to noise ratios and impedance matching and provides the further advantage of permitting the use of floating input or output windings if desired in any application.

A specific embodiment of a bi-quad amplifier which can be used for each of the amplifiers 41 and 42 in Fig. 4 is depicted in Fig. 6 as comprising three operational amplifier (op-amp) stages and having a closed loop feedback resistor $R_a$ connected from the output of the final op-amp to the input of the initial op-amp. The overall circuit operates in effect as a parallel resonant circuit the amplitude characteristics of which rise from a zero level to a peak at the resonant frequency and then fall to the same zero level. The phase goes from $+90°$ at low frequencies through $0°$ at the resonant frequency to $-90°$ at high frequencies.

Accordingly, when used in the band-pass amplifier configuration of Fig. 4, the overall operation thereof provides the desired closed loop amplitude and phase characteristics shown in Fig. 5. The amplitude vs. frequency characteristic provides a substantially flat response (a constant gain) in the relatively narrow pass band region about the center frequency, $f_r$, reduces rapidly to low levels near the resonance pass band, and approaches zero at extreme off-resonant frequencies. The phase shift is zero over the pass band and is effectively $+90°$ or $-90°$ elsewhere, as shown.

The output from the band-pass filter/amplifier 23 is then supplied to phase detector/filter 24, the phase detector portion of which, as shown in Fig. 7, comprises synchronous detector circuits 45, 46, 47 and 48 which are supplied with synchronous signals M, $\overline{M}$, N and $\overline{N}$, respectively, (where the "barred" terms are the inverse waveforms of the non-barred terms). The waveforms of such signals are shown in Fig. 8. Over the time period T representing the period of the resonant frequency $F_r$ the wave shapes are of the form shown wherein each is at maximum at one or the other polarity (i.e., $\pm 1$) during the middle third of its half cycle, and is zero otherwise.

The detector circuit of Fig. 7 is functionally equivalent to the simplified circuitry shown in Fig. 9 and can be used to illustrate the operation thereof. In Fig. 9 an input A-C signal $E_S$ (as from a generator 50) is supplied directly to one terminal $S_1$ of switch 51 and the inverted A-C signal ($-E_S$) is supplied to another terminal $S_2$ of switch 51. The center terminal is grounded. If $E_S$ has the waveform (A) shown (for one cycle) in Fig. 10 and the switch is operated as shown by waveform (B), the detected output $E_0$ is of the form shown by waveform (C). The third harmonic of the input signal, $E_{S3}$, is shown by waveform (D) and the third harmonic of the output signal $E_{03}$, is shown by waveform (E). As can be seen, in the latter waveform the areas of the positive output third harmonic portions are essentially equal to those of the negative portions thereof so that the third harmonic output essentially averages out to zero and is effectively eliminated. Such operation can be contrasted with a conventional square wave detector in which the presence of third harmonics adversely affects detector operation in many applications. Such operation also substantially reduces the fifth harmonics by a factor of four.

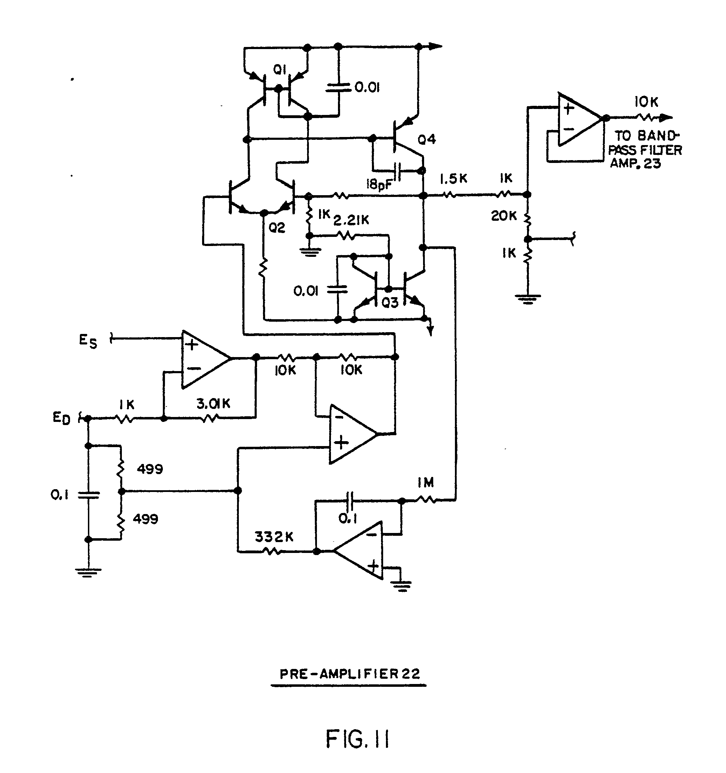

Fig. 11 depicts the preamplifier stage 22, the elements used therein having selected values as shown for a particular operating embodiment of the invention. A particular operating embodiment of the band-pass filter/amplifier 23 has already been shown in Figs. 4 and 6, while the phase detector/filter configuration 24 has been shown in Fig. 7.

The Bessell filter 27 is a well-known two-pole filter, the characteristic of which is that its output becomes essentially completely stablized in response to a step signal input more rapidly than other filters having equivalent attenuation characteristics. The filter also provides effective attenuation of the beat frequency signals which result between the center frequency (e.g., 384 Hz as selected for use in the particular embodiment discussed) and the seventh harmonic of the line frequency (i.e., either 60 Hz or 50 Hz, for example) which line signal harmonic is closest to the center frequency. In some applications it may be desirable to achieve more effective operation by providing a conventional four-pole Bessel filter instead of the two-pole version.

The output from phase detector/filter 24 is also supplied to finite time integrator 16. The outputs from integrators 16 and 17 are supplied through appropriate switching means 21 to limiter 18 as depicted in Fig. 2 to provide the output signal which is thereupon supplied to up/down counter 19 as shown in the configuration of Fig. 1. Thus, during the most significant bit operating mode, the switches shown in Fig. 1 are in their dashed-line positions wherein the output from preamplifier 22 by-passes the band-pass filter circuit 23 and is supplied directly to phase detector/filter 24 and thence to finite time integrator 16 for supply to limiter 18. During the least significant bit operating mode the switches are in their alternate positions wherein the output of preamplifier 22 is supplied to band-pass filter/amplifier 23, to phase detector/filter 24 and, thence, to Bessel filter 27 and dual-slope integrator 17 before being supplied to limiter 18.

In the timing sequence of operation of the system of Fig. 1, for an overall computation time of 1.25 seconds, divided into fifteen 83 1/3 millisecond (msec.) segments, the most significant bit computation occurs in segment 0, the first 83 1/3 msec. Once the filters become stabilized in segment 11, the least significant bit measurement begins. In such operation the dual-slope integrator first integrates up, or down, depending on the polarity of the error voltage of the input to preamplifier 22. Such first upslope (downslope) integration occurs over a time period from segment 2 through segment 9 at which point the integrator output reaches a steady state value. Segment 10 is used to stabilize the filters (the integrator maintains its steady state value) and the downslope (or upslope) integration occurs from segment 10 through segment 14. The direction of such second integration depends on the polarity of the A-C reference signal supplied via switch 32 which is selected in accordance with the direction of the first integration.

During such operation, switches 25, 26, 29 and 21 are in their dashed line positions during the MSB operating mode (segment 0) and in their solid line positions during the stabilizing segment (segments 1 and 10) and during the LSB operating mode (segments 2—9 and 11—14). Switch 28 is in its dashed line position during the MSB operating mode and during the stabilizing time segments (segments 1 and 10) so as to assure that dual-slope integrator 17 begins its integration with a zero input during both integration time periods. Switch 28 is in its solid lines position during the LSB dual-slope integrations (segments 2—9 and 11—14).

Because the error signal and the selected A—C reference signal both utilize the same components during such dual-slope integration process, any changes in the characteristics of such components affect the two integrations in the same manner and no error arises in the integration process due to any such component changes.

Thus, the operation of the circuitry depicted and discussed with reference to Figs. 1—11 provides a more effective and improved operation over that which is described in the above-referenced U.S. patent No. 4,536,744, and permits the generation of the least significant bits in a manner which is not adversely affected by the problem of harmonic presence, particularly the presence of third harmonics, in the A-C reference oscillator. In accordance with the circuitry described above, the circuitry responds essentially only to the fundamental frequency of the basic oscillator circuit and the desired improved resolution and accuracy of the digital output signal can be better achieved.

## Claims

1. An analog-to-digital converter circuit for providing an n-bit digital signal representative of the amplitude of an A.C. input signal ($E_S$), where n is an integer greater than one, said circuit comprising:

a digital-to-analog converter circuit (12) for providing a first A.C. output signal ($E_D$) based on the most significant bits of said n-bit digital signal;

comparator circuit means (14) for comparing said first A.C. output signal ($E_D$) with said A.C. input signal ($E_S$) to provide a digital output signal, said comparator circuit means including:

first circuit means (22) for providing a difference signal representing the difference between said first A.C. output signal ($E_D$) and said A.C. input signal ($E_S$);

first integrating means (16) responsive to said difference signal during a first time interval for integrating said difference signal over said first time interval to produce a first integrated signal; characterised by:

limiter means (18) responsive to said first integrated signal over said first time interval for limiting said first integrated signal to produce said digital output signal during said first time interval;

filter means (23) responsive to said difference signal during a second time interval for producing a filtered difference signal in which harmonic components of said difference signal are substantially eliminated;

second integrating means (17) responsive to said filtered difference signal for integrating said filtered difference signal in a first direction over a predetermined first portion of said second time interval, and for further integrating a reference signal in a direction opposite to said first direction over a second portion of said second time interval;

said limiter means (18) being responsive to the output of said second integrating means for producing said digital output signal during said second time interval; and

said circuit further comprising:

means (19, 15, 13) including a counter, said means responsive to said digital output signal during said first and second time intervals for producing first and second digital signals representing the most significant bits and the least significant bits of said n-bit digital signal respectively.

2. An analog-to-digital converter circuit in accordance with claim 1 wherein said filter means in a band-pass filter (23) having substantially zero phase shift at the fundamental frequency of said difference signal and a relatively small gain at substantially all frequencies other than frequencies in a pass band at or near said fundamental frequency.

3. An analog-to-digital converter circuit in accordance with claim 2 wherein said band-pass filter (23) comprises:

first operational-amplifier means (41) responsive to said difference signal and arranged for effectively providing a first tuned circuit tuned to said fundamental frequency;

second operational-amplifier means (42) responsive to the output of said first operation-amplifier means and arranged for effectively providing a second tuned circuit tuned to said fundamental frequency;

said first and second operational-amplifier circuits thereby providing said band-pass filter operation.

4. An analog-to-digital converter circuit in accordance with claim 3 wherein said second operational-amplifier means includes bi-quad amplifier means (42).

5. An analog-to-digital converter circuit in accordance with claims 1, 2, 3 or 4 and further including

phase detector means (24) responsive to said difference signal during said first time interval for providing a phase detected difference signal to said first integrating means (16) and responsive to said filtered difference signal from said filter means (23) during said second time interval for supplying a phase detected filtered difference signal to said second integrating means (17).

6. An analog-to-digital converter circuit in accordance with claim 5 and further including low pass filter means (27) responsive to said phase detected difference signal during said second time interval for providing a low pass filtered phase detected difference signal in which higher harmonic components of said phase detected difference signal are substantially eliminated.

7. An analog-to-digital converter circuit in accordance with claim 6 wherein said low pass filter means (27) is a Bessel filter.

8. An analog-to-digital converter circuit in accordance with claim 5 wherein said phase detector means includes:

a plurality of synchronous detector circuits (45, 46, 47, 48) each responsive to said band-pass filter signal and further responsive to a plurality of reference signals having wave shape characteristics selected to eliminate third harmonic components of said band-pass filtered signal.

9. An analog-to-digital converter circuit in accordance with claim 8 wherein said synchronous detector circuits include two pairs of synchronous detectors, a first pair (45, 46) being responsive respectively to a first reference signal (M) and to a second reference signal ($\overline{M}$) which is the inverse of said first reference signal and a second pair (47, 48) being responsive respectively to a third reference signal (N) and to a fourth reference signal ($\overline{N}$) which is the inverse of said third reference signal.

10. An analog-to-digital converter circuit in accordance with claim 9 wherein the wave shapes of said first and second reference signals (M and $\overline{M}$) are arranged so that during each cycle of said fundamental frequency said signals are at a maximum during the middle two-thirds of the first half of said cycle and are zero at all other times during said cycle and said third and fourth reference signals (N and $\overline{N}$) are arranged so that over each cycle of said fundamental frequency such signals are at a maximum during the middle two-thirds of the second half of said cycle and are zero at all other times during said cycle.

**Patentansprüche**

1. Analog/Digital (A/D)-Wandler-Schaltung zur Bereitstellung eines die Amplitude eines A.C.-Eingangssignale ($E_s$) repräsentierenden n-Bit-Digitalsignals, wobei n eine ganze Zahl größer als eins ist und die genannte Schaltung folgendes enthält:

—eine D/A-Wandler-Schaltung (12) zur Bereitstellung eines ersten, auf den signifikantesten Bits des genannten n-Bit-Digitalsignals basierenden A.C.-Ausgangssignals ($E_D$),

—Komparator-Schaltungsmittel (14) zum Vergleichen des genannten ersten A.C.-Ausgangssignals ($E_D$) mit dem genannten A.C.-Eingangssignal ($E_s$) zum Bereitstellen eines digitalen Ausgangssignals, wobei die genannten Komparator-Schaltungsmittel folgendes aufweisen:

—erste Schaltungsmittel (22) zur Erzeugung eines Differenzsignals, das die Differenz zwischen dem genannten ersten A.C.-Ausgangssignal ($E_D$) und dem genannten A.C.-Eingangssignal ($E_s$) darstellt,

—auf das genannte Differenzsignal während eines ersten Zeitintervalls ansprechende erste Integriermittel (16) zur Integration des genannten Differenzsignals über dem genannten ersten Zeitintervall und Erzeugung eines ersten integrierten Signals, gekennzeichnet durch,

—Begrenzermittel (18), die über das gesamte erste Zeitintervall auf das genannte erste integrierte Signal ansprechen, zur Erzeugung des genannten digitalen Ausgangssignals während des genannten Zeitintervalls,

—Filtermittel (23), die während eines zweiten Zeitintervalls auf das genannte Differenzsignal reagieren, um ein gefiltertes Differenzsignal zu erzeugen, in dem harmonische Anteile des genannten Differenzsignals im wesentlichen eliminiert sind,

—zweite Integriermittel (17), die auf das genannten gefilterte Referenzsignal ansprechen zur Integrations des genannten gefilterten Differenzsignals in einer ersten Richtung über einen vorbestimmten ersten Teil des genannten zweiten Zeitintervals und ferner zur Integration eines Bezugsignals in einer zur genannten ersten Richtung entgegengesetzten Richtung über einen zweiten Teil des genannten zweiten Zeitintervalls,

—wobei die genannten Begrenzermittel (18) der Ausgang der genannten zweiten Integriermittel zur Erzeugung des genannten digitalen Ausgangssignals während des genanten zweiten Zeitintervalls zugeordnet ist und

—wobei die genannte Schaltung darüberhinaus Mittel (19, 15, 13), einschließlich eines Zählers aufweist, und diese Mittel auf das genannte digitale Ausgangssignal während des gesamten ersten und zweiten Zeitintervalls reagieren, um erste und zweite Digitalsignal zur erzeugen, welche die signifikantesten bzw. die am wenigstens signifikanten Bits des genannten n-Bit-Digitalsignals repräsentieren.

2. A/D-Wandler-Schaltung nach Anspruch 1, dadurch gekennzeichnet, daß die genannten Filtermittel ein Bandpaßfilter (23) sind, das bei der Grundfrequenz des genannten Differenzsignals im wesentlich keine Phasenverschiebung aufweist und bei praktisch allen Frequenzen außer Frequenzen in einem Durchlaßbereich bei oder nahe der Grundfrequenz eine verhältnismäßig geringe Verstärkung hat.

3. A/D-Wandler-Schaltung nach Anspruch 2, dadurch gekennzeichnet, daß das genannte Bandpaßfilter (23) aufweist:

—erste Operationsverstärker-Mittel (41), die auf das genannte Differenzsignal ansprechen und zur wirksamen Versorgung eines ersten, auf die genannte Grundfrequenz abgestimmten Schwingkreises vorgesehen sind,

—zweite Operationsverstärker-Mittel (42), die dem Ausgang der genannten ersten Operationsverstärker-Mittel zugeordnet und zur wirksamen Versorgung eines zweiten, auf die genannte Grundfrequenz abgestimmten Schwingkreises vorgesehen sind,

wodurch die genannten ersten und zweiten Operationsverstärker-Schaltungen den genannten Bandpaßbetrieb besorgen.

4. A/D-Wandler-Schaltung nach Anspruch 3, dadurch gekennzeichnet, daß die genannten zweiten Operationsverstärker-Mittel bi-quad-Verstärkermittel (42) beinhalten.

5. A/D-Wandler-Schaltung nach Anspruch 1, 2, 3 oder 4, dadurch gekennzeichnet, daß sie ferner Phasendetektor-Mittel (24) enthält, die auf das genannte Differenzsignal während des genannten ersten Zeitintervalls ansprechen zur Lieferung eines phasendetektierten Differenzsignals an die genannten ersten Integriermittel (16) und die auf das genanntergefilterte Differenzsignal der genannten Filtermittel (23) während des genannten zweiten Zeitintervalls reagieren zur Lieferung eines phasendetektierten gefilterten Differenzsignals an die genannten zweiten Integriermittel (17).

6. A/D-Wandler-Schaltung nach Anspruch 5, dadurch gekennzeichnet, daß sie weiterhin auf das genannte phasendetektierte Differenzsignal während des genannten zweiten Zeitintervalls ansprechende Tiefpaß-Filtermittel (27) zur Bereitstellung eines tiefpaßgefilterten phasendetektierten Differenzsignals enthält, in dem harmonische Komponenten höherer Ordnung im wesentlich eliminiert sind.

7. A/D-Wandler-Schaltung nach Anspruch 6, dadurch gekennzeichnet, daß die genannten Tiefpaß-Filtermittel (27) ein Besselfilter sind.

8. A/D-Wandler-Schaltung nach Anspruch 5, dadurch gekennzeichnet, daß die Phasendetektor-Mittel eine Vielzahl von synchronen Detektorschaltungen (45, 46, 47, 48) enthalten, deren jedes auf das gesamte Bandpaßfilter-Signal und darüberhinaus auf eine Vielzahl von Bezugssignalen ansprechen, deren Wellenformcharakteristika derart gewählt sind, daß harmonische Komponenten dritter Ordnung des genannten bandpaßgefilterten Signals eliminiert werden.

9. A/D-Wandler-Schaltung nach Anspruch 8, dadurch gekennzeichnet, daß die genannten synchronen Detektorschaltungen zwei Paare synchroner Detektoren enthalten, wobei ein erstes Paar (45, 46) auf ein erstes Bezugssignal (M) bzw. auf ein zweites, zum erstes inverses Bezugssignal (M̄) anspricht und wobei ein zweites Paar (47, 48) auf ein drittes Bezugssignal (N) bzw. auf ein viertes, dazu inverses Bezugssignal (N̄) reagiert.

10. A/D-Wandler-Schaltung nach Anspruch 9, dadurch gekennzeichnet, daß die Wellenformen der genannten ersten und zweiten Bezugssignale (M und M̄) derart festgelegt sind, daß während jeder Periode der genannten Grundfrequenz die genannten Signale während der mittleren Zweidrittel der ersten Halbperiode einen maximalen Wert und während der ganzen übrigen Periodendauer den Wert Null aufweisen und daß die genannten dritten und vierten Bezugssignal (N und N̄) derart festgelegt sind, daß während jeder Periode der genannten Grundfrequenz diese Signale während der mittleren Zweidrittel der zweiten Halbperiode ein Maximum und während der restlichen Periodendauer den Wert Null aufweisen.

**Revendications**

1. Circuit de convertisseur analogique-numérique destiné à produire un signal numérique à n bits représentant l'amplitude d'un signal alternatif d'entrée (E$_S$), où n est un nombre entier supérieur à l'unité, ledit circuit comportant:

un circuit convertisseur numérique-analogique (12) destiné à produire un premier signal alternatif de sortie (E$_D$) sur la base des bits les plus significatifs dudit signal numérique à n bits,

des moyens de circuit comparateur (14) destinés à comparer le premier signal alternatif de sortie (E$_D$) avec ledit signal alternatif d'entrée (E$_S$) de manière à produire un signal numérique de sortie, lesdits moyens de circuit comparateur comportant:

des premiers moyens de circuit (22) destinés à produire un signal de différence représentant la différence entre ledit premier signal alternatif de sortie (E$_D$) et ledit signal alternatif d'entrée (E$_S$),

des premiers moyens d'intégration (16) réagissant audit signal de différence pendant un premier intervalle de temps en intégrant ledit signal de différence pendant ledit premier intervalle de temps de manière à produire un premier signal intégré caractérisé en ce qu'il comporte:

des moyens limiteurs (18) réagissant audit premier signal intégré pendant ledit premier intervalle de temps en limitant ledit premier signal intégré pour produire ledit signal numérique de sortie pendant ledit premier intervalle de temps,

des moyens de filtrage (23) réagissant audit signal de différence pendant un second intervalle de temps en produisant un signal de différence filtré dans lequel les composantes harmoniques dudit signal de différence sont pratiquement éliminées,

des seconds moyens d'intégration (17) réagissant audit signal de différence filtré en intégrant ledit signal de différence filtré dans une première direction, pendant une première partie prédéterminée dudit second intervalle de temps et en intégrant en outre un signal de référence dans une direction opposée à ladite première direction pendant une seconde partie dudit second intervalle de temps,

lesdits moyens limiteurs (18) réagissant à la sortie desdits seconds moyens d'intégration en produisant ledit signal numérique de sortie pendant ledit second intervalle de temps, et

ledit circuit comportant en outre:

des moyens (19, 15, 13) comprenant un compteur, lesdits moyens réagissant audit signal numérique de sortie pendant ledit premier et ledit second intervalles de temps en produisant des premiers et des seconds signaux numériques représentant les bits les plus significatifs et les bits les moins significatifs, respectivement dudit signal numérique à n bits.

2. Circuit de convertisseur analogique-numérique selon la revendication 1, dans lequel lesdits moyens de filtrage consistent en un filtre passe-bande (23) apportant un déphasage pratiquement nul à la fréquence fondamentale dudit signal de différence et un gain relativement faible à pratiquement toutes les fréquences autres que les fréquences dans une bande passante au voisinage ou à ladite fréquence fondamentale.

3. Circuit de convertisseur analogique-numérique selon la revendication 2, dans lequel ledit filtre passe-bande (23) comporte:

des premiers moyens d'amplificateur opérationnel (41) réagissant audit signal de différence et agencés pour former effectivement un premier circuit accordé, accordé sur ladite fréquence fondamentale,

des seconds moyens d'amplificateur opérationnel (42) réagissant à la sortie desdits premiers moyens d'amplificateur opérationnel et agencés pour former effectivement un second circuit accordé, accordé sur ladite fréquence fondamentale,

lesdits premier et second circuits d'amplificateurs opérationnels réalisant ainsi ladite opération de filtrage passe-bande.

4. Circuit de convertisseur analogique-numérique selon la revendication 3, dans lequel lesdits seconds moyens d'amplificateur opérationnel comprennent des moyens d'amplificateur bi-quadruples (42).

5. Circuit de convertisseur analogue-numérique selon la revendication 1, 2, 3 ou 4, et comportant en outre,

des moyens de détection de phase (24) réagissant audit signal de différence pendant ledit premier intervalle de temps en produisant un signal de différence de phase détectée pour lesdits premiers moyens d'intégration (16) et réagissant audit signal de différence filtré provenant desdits moyens de filtrage (23) pendant ledit second intervalle de temps en fournissant un signal de différence filtré, de phase détectée, auxdits seconds moyens d'intégration (17).

6. Circuit de convertisseur analogique-numérique selon la revendication 5 et comportant en outre des moyens de filtrage passe-bas (27) réagissant audit signal de différence de phase détectée pendant ledit second intervalle de temps en produisant un signal de différence de phase détectée, filtré passe-bas dans lequel les composantes d'harmoniques supérieures dudit signal de différence de phase détectée sont pratiquement éliminées.

7. Circuit de convertisseur analogique-numérique selon la revendication 6, dans lequel lesdits moyens de filtrage passe-bas (27) consistent un filtre de Bessel.

8. Circuit de convertisseur analogique-numérique selon la revendication 5, dans lequel lesdits moyens de détection de phase comprennent:

plusieurs détecteurs synchrones (45, 46, 47, 48) réagissant chacun audit signal du filtre passe-bande et réagissant en outre à plusieurs signaux de référence ayant des caractéristiques de forme d'onde sélectionnées pour éliminer les composantes de troisièmes harmoniques dudit signal filtré passe-bande.

9. Circuit de convertisseur analogique-numérique selon la revendication 8, dans lequel lesdits circuits détecteurs synchrones comprennent deux paires de détecteurs synchrones, une première paire (45, 46) réagissant respectivement à un premier signal de référence (M) et à un second signal de référence ($\overline{M}$) qui est l'inverse dudit premier signal de référence et une seconde paire (47, 48) réagissant respectivement à un troisième signal de référence (N) et à un quatrième signal de référence ($\overline{N}$) qui est l'inverse dudit troisième signal de référence.

10. Circuit de convertisseur analogique-numérique selon la revendication 9, dans lequel les formes d'onde dudit premier et dudit second signaux de référence (M et $\overline{M}$) sont agencées de manière que pendant chaque cycle de ladite fréquence fondamentale, lesdits signaux soient à un maximum pendant les deux tiers médians de la première moitié dudit cycle et soient nuls à tous autres moments pendant ledit cycle et lesdits troisième et quatrième signaux de référence (N et $\overline{N}$) sont agencés de manière que pendant chaque cycle de ladite fréquence fondamentale, ces signaux soient à un maximum pendant les deux tiers médians de la seconde moitié dudit cycle et soient nuls à trous autres moments pendant ledit cycle.

FIG. I

A–C COMPARATOR CIRCUIT

FIG. 2

FIG.3

FIG.4

FIG.5

BI-QUAD AMP. 41 OR 42

FIG. 6

M    N    N̄

SYN.
DET.    47

100 K

SYN.
DET.    48

E1    0.01

FROM BAND PASS FILTER /
AMPLIFIER 23 (FIG.4)

SYN.
DET.    45

E2

TO BESSEL FILTER 27
& FINITE TIME
INTEGRATOR 16

M̄

SYN.
DET.    46

FIG.7

PHASE DETECTOR / FILTER 24

T

1/12    1/3    1/6    1/3    1/12

M

M̄

N

N̄

FIG.8

(A) $E_S$

(B) $S_1$
$S_2$

(C) $E_0$

(D) $E_{s3}$

(E) $E_{03}$

50    $E_S$

$-1$    $-E_S$    $S_2$

$S_1$    51

FIG.9

FIG.10

PRE-AMPLIFIER 22

FIG. 11